# EUROPEAN PATENT SPECIFICATION

(11) **EP 0 578 487 B1**
(45) Date of publication and mention of the grant of the patent: **09.10.1996**
(21) Application number: 93305322.5
(22) Date of filing: 07.07.1993
(51) Int. Cl.: H01R 23/72

(54) **Electrical pin field**
Elektrisches Stiftfeld
Réseau broches électriques

(30) Priority: 08.07.1992 GB 9214524
(43) Date of publication of application: 12.01.1994
(73) Proprietor: THE WHITAKER CORPORATION, Wilmington, Delaware 19808 (US)
(72) Inventor: Broeksteeg, Johannes, NL-5341 AG OSS (NL)
(74) Representative: Warren, Keith Stanley

(56) References cited:
- EP-A- 0 195 955
- EP-A- 0 428 259
- US-A- 4 753 601
- US-A- 4 836 791

## Description

The present invention relates to a pin field inserted in a printed circuit board, with back-to-back headers positioned on opposite sides of the printed circuit board.

It is well known to form a pin field in printed circuit boards. These pins would be electrically connected to circuit traces in a printed circuit board, by way of press fit, such as for example by way of compliant pin portions within the printed circuit board through hole. Extending in opposite directions from the compliant pins, are pin portions, profiled for mating with complementary terminals in a complementary connector. Housings are positioned over the pins on opposite sides of the printed circuit boards to form a completed connector assembly. A difficulty which has arisen, is the method of retaining the housings to the pin field.

The printed circuit boards of the subject pinfields may have through holes having a diameter as small as 0.55 mm in diameter. Thus, the pin has on one side of the compliant pin portion, an enlarged barb which is larger than the nominal width of the pin and which is profiled for interference fit within the corresponding housing. However, as the pin must be inserted through the printed circuit board through hole, the side of the pin opposite the entry side of the printed circuit board cannot contain a retaining barb, as it would not fit through the printed circuit board. Therefore, on one side of the printed circuit board, the pin is of a constant width, sometimes as narrow as 0.50 mm. The housings which enclose these pins generally have passageways which are intereference fit with the pins.

One of the drawbacks to this approach is that, as the housings are inserted over the pin field, the housings interfere with the pin field, and leave some of the plastic on the pins themselves which could lead to an unstable contact, as the plastic is directly on the contact surfaces. Thus, as the mating contact receptacle could have plastic particles between the contact surfaces and the pin itself, an ineffective contact could be made. Secondly, as many housings are made from glass filled housings, the glass particles in the hcusing could actually skive through the gold plating on the contacts, again leading to an ineffective contact system.

An object of the invention then is to provide an electrical connector system, and preferably a pin field, where two headers can be attached back-to-back on a printed circuit board and where the installation of the second header causes no instability to its associated contact.

The invention is directed to an electrical pin field comprising a printed circuit board having a plurality of pins extending between both sides thereof to position pin contact portions on opposite sides of the board. The pin field has insulating housings mounted on both sides of the board. Such a pin field is, for example, disclosed in EP-A-0 422 785. The pin field according to the present invention is characterized in that at least one of the housings includes a locking plate medially positioned between the board and the housing, the locking plate having a plurality of through holes for receiving the pins and at least one gripping arm extending towards the housing adjacent to each through hole and being an interference fit with a passageway in the housing and positioned against a pin.

An embodiment of the present invention will now be described by way of example with reference to the accompanying drawings in which:
Figure 1 is a cross-sectional view showing a first header mounted to the lower side of a printed circuit board with the spacer member and second header poised for receipt over the pin field;
Figure 2 is a top view of the spacer plate;
Figure 3 is a side view of the spacer plate;
Figure 4 is a lower plan view of the spacer plate;
Figure 5 is a cross-sectional view through lines 5-5 of Figure 4;
Figure 6 is a plan view of a portion of the electrical pins used for the pin field;
Figure 7 is a view similar to that of Figure 1 showing the initial reception over the header of the spacer plate;

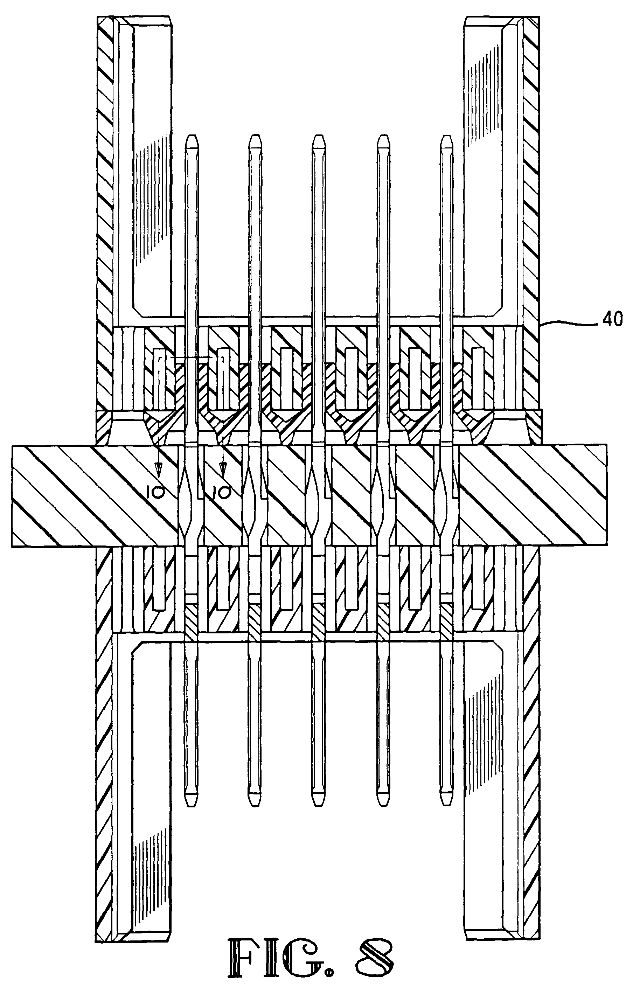

Figure 8 is a view similar to that of Figure 7 showing the fully assembled spacer plate and header on the pin field;
Figure 9 is a cross-sectional view through lines 9-9 of Figure 7; and
Figure 10 is a cross-sectional view through lines 10-10 of Figure 8.

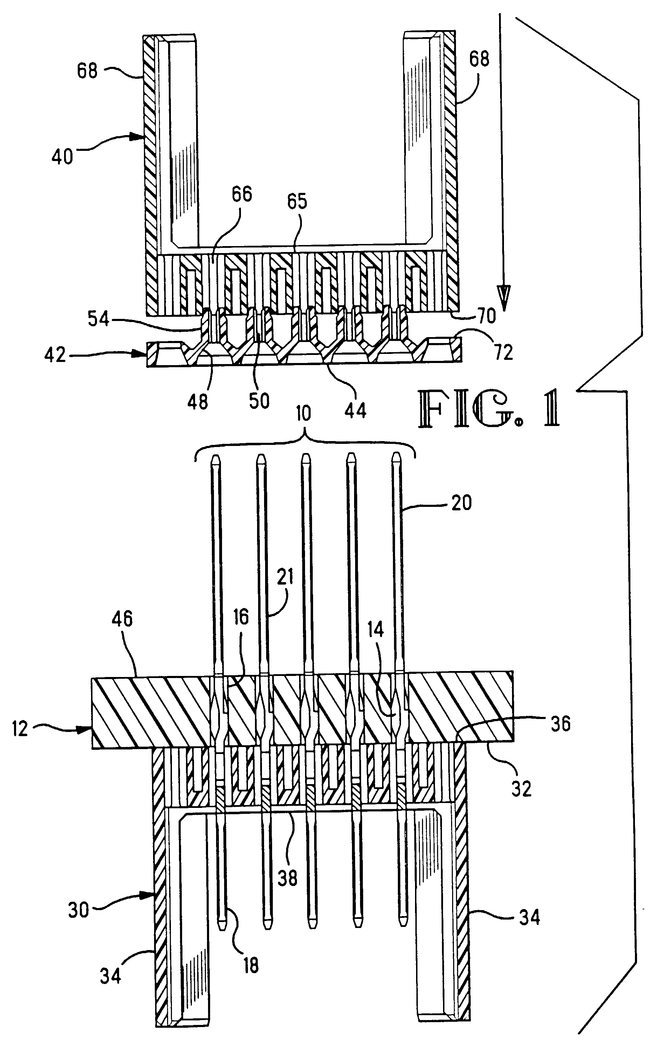

With reference first to Figure 1, an electrical pin field is shown generally by a plurality of pins 10 positioned on the printed circuit board 12, the pins being retained in position on the printed circuit board by compliant portions 14 on the pins inserted into throughholes 16 on the printed circuit board. The pins 10 generally include contact sections 18 on one side of the printed circuit board and contact sections 20 on the opposite side, the contact sections 18 and 20 being profiled for receiving complementary plug connectors in electrical engagement.

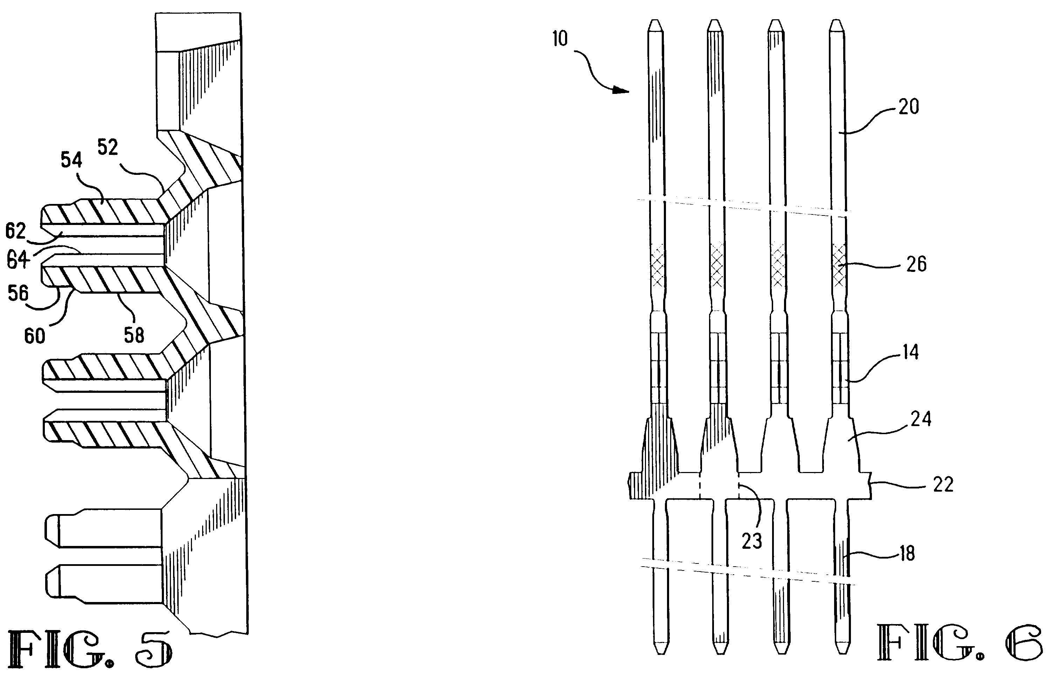

With respect now to Figure 6, the electrical pins 10 are shown as they are formed on a carrier strip such as 22 for reeling, or for assembly purposes with the electrical housings. The terminals 20 will be sheared from the carrier strip 22 at phantom lines 23 for end use. The compliant portions are shown generally at 14 with enlarged portions shown at 24 which will be used for retaining the pin terminals within their respective housings, as will be described in greater detail herein. The contact portions 20 are shown above the compliant section 14 whereas the compliant portions 18 are shown positioned below the compliant portions 14. The surfaces at 26 are roughened to provide a greater frictional surface as will be described in greater detail herein.

With reference again to Figure 1, a housing member 30 made from an insulating material is positioned over the contact portions 18 of the pins 10 to form a header assembly on the lower side 32 of the printed circuit board 12. This header assembly could be similar to that shown in EP-A- 0 422 785. This housing 30 generally comprises upstanding sidewalls 34 on either side thereof which provides an opening for a complementary plug connector which could either be shielded or unshielded. With reference again to Figure 6, it should be noted that the enlarged sections 24 of the terminals 10 are positioned medially of the contact portions 18 and the compliant pin portions 14. The insulating housing 30 is profiled to receive the contact portions 18 from a rear side 36 of the housing 30.

Thus as mentioned above, the pin field comprising the plurality of pins 10 can either be positioned in the printed circuit board 12, and then later receive the housing member 30 thereover such that the housing member 30 is positioned with the mounting face 36 facing the surface 32 of the printed circuit board and then forced against the printed circuit board. Alternatively, the pins 10 could be forced in the housing member 30 and the header assembly comprising the housing 30 and the pins 10 could be placed against the lower side 32 of the printed circuit board 30. In either case, it should be appreciated that the enlarged portions 24 of the terminals 10 prevent removal of the housings over the terminals, the housing 30 being profiled to receive the enlarged section 24 therein.

In the preferred embodiment of the invention, the terminals 10 are profiled to be received in a printed circuit board throughhole having a 0.55 mm diameter. Therefore as the pins must pass through the printed circuit board, with the contact portion 20 leading, this prevents having an enlarged portion similar to 24 on the opposite side of the compliant pin portion 14 for retaining another housing thereto. Also as mentioned above, previous connectors have held the opposing housing to the contacts and to the printed circuit board by providing an interference fit between the contacts, for example at 20, with the throughholes in the housing such that the housing interferingly fits during the entire insertion of the connector housing over the pin field at 10.

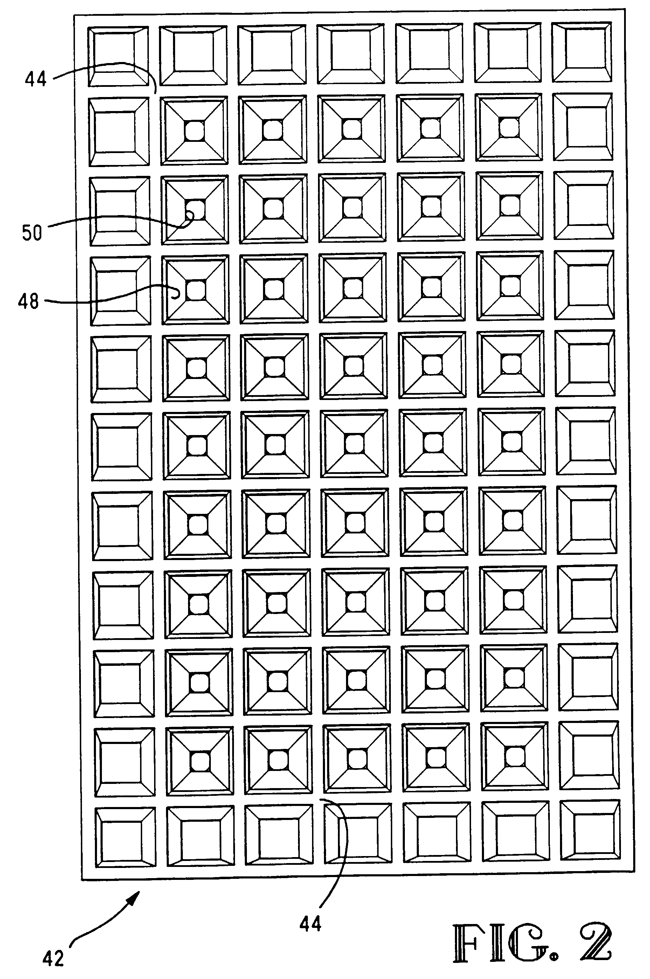

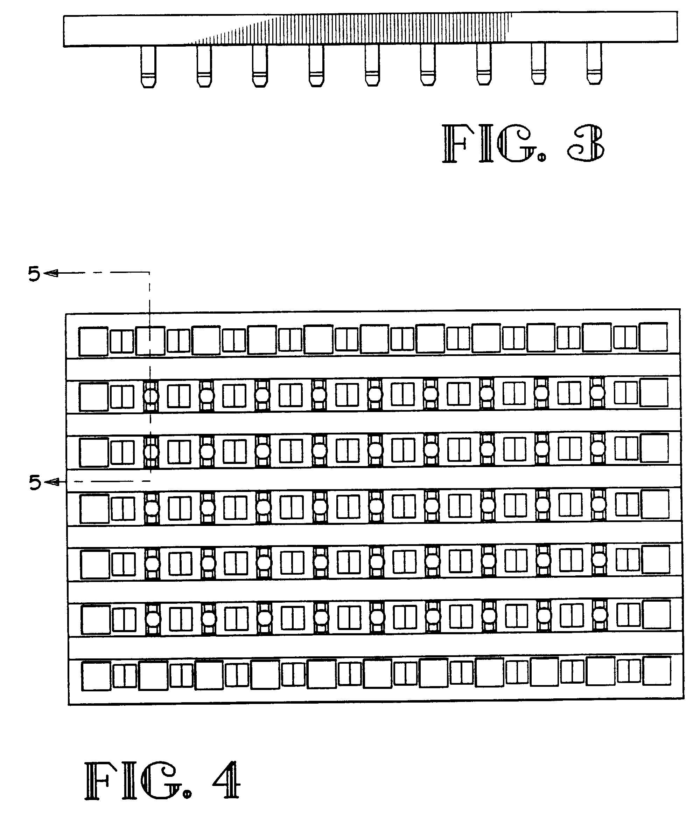

In the present embodiment, there is provided an improved housing having a locking spacer plate 42. As shown best in Figure 2, the spacer plate 42 has a lower face at 44 which is profiled for receipt against an upper surface 46 of the printed circuit board 12. The locking spacer plate 42 includes a plurality of lead-in openings 48 for easy placement of the locking spacer member 42 over the pin field at 10. Movement of the plate 42 over the pin field, centers each of the pins 10 with a central throughhole 50 in the spacer plate 42. As shown best in Figures 3-5, the spacer plate 42 has an opposite surface 52 including gripping or locking arms 54 extending from opposite sides of the opening 50. As shown best in Figure 5, the locking arms 54 include thin portions 56 adjacent to the distal ends thereof and thickened portions 58 defined through transition sections 60. Also with reference to Figures 5 and 9, the surfaces facing the pins 10 have cylindrical surfaces 62 forming outer tip surfaces at 64.

With reference again to Figure 1, the housing member 40 is similar in nature to the housing member 30, including a central section at 65 having a plurality of terminal passageways at 66 and sidewalls at 68 for receiving a complementary plug member. The housing member 40 further includes a lower mounting surface 70 which can be placed against a mounting surface 72 of the spacer member 42 when in the final position. As best shown in Figure 9, the housing passageways 66 are cruciform in configuration including end portions 68 which receive the locking arms 54 and side portions 70.

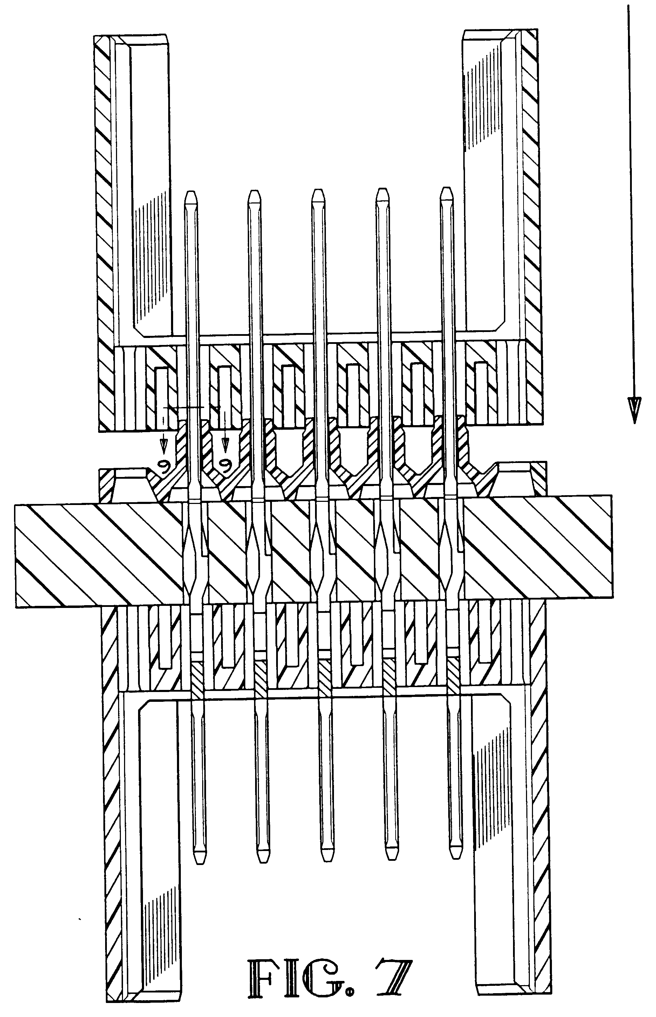

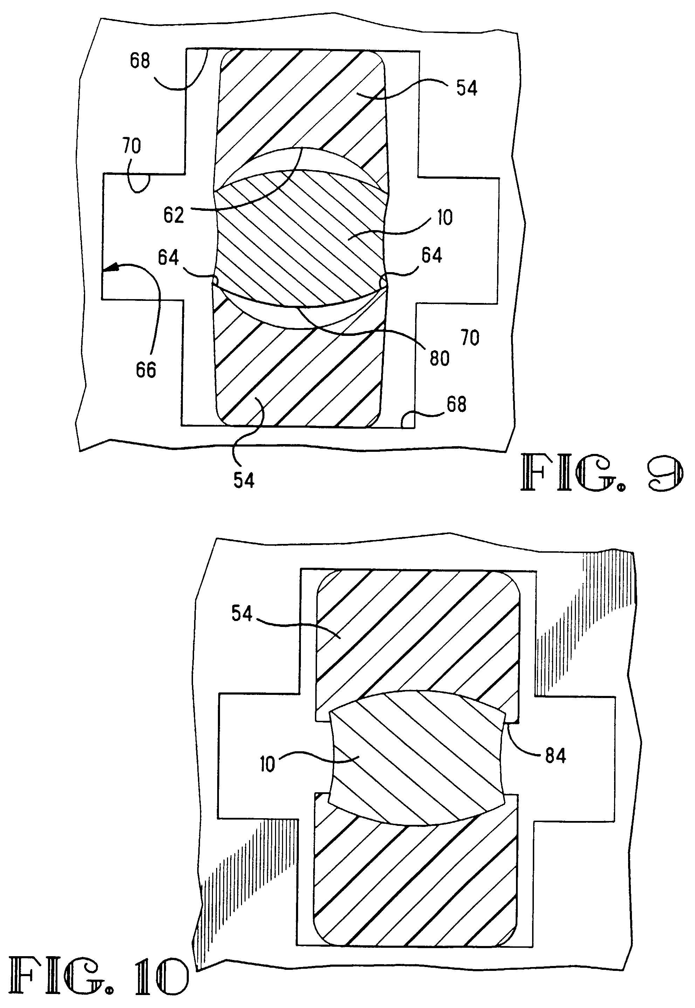

With the pin field 10 and the housing member 30 applied to the printed circuit board 12 as shown in Figure I and as described above, the housing member 40 can now be applied to the printed circuit board 12 by way of the locking spacer 42. The spacer member 42 can be attached to the housing member 40, as shown in Figure 1, and applied over the pin field 10 such that the lead in portions 48 are aligned with each of the pins 10, and the spacer plate 42 can then be lowered until the surface 44 of the spacer member 42 abuts the surface 46 of the printed circuit board. It should be appreciated that, when in the position shown in Figure 7, there is little resistance between the locking arms 54 and the pins 10, as the narrowed portions 56 of the retaining arms 54 provide little interference with the pins 10. This is best shown in Figure 9 where the outer tips 64 only contact the outer edges of the pin member 10. In the preferred embodiment of the invention, the pin is barrel shaped in cross-section, as shown in Figures 9 and 10 to cooperate with the contact arms 54.

Further movement of the housing member 40 against the spacer plate 42 causes interference between the locking arms 54 and the pin member 10 by way of the enlarged sections 58 of the locking arms 54. This interference fit causes plastic material to flow around the edges of the pin 10 for example as shown at 84 in Figure 10. In this manner, the locking arms 54 are in gripping position against the roughened portions 26, to thereby retain the housings to the printed circuit board.

## Claims

1. An electrical pin field comprising a printed circuit board (12) having a plurality of pins (10) extending between both sides thereof to position pin contact portions (18,20) on opposite sides of the board (12), the pin field having insulating housings (30,40) mounted on both sides of the board (12), characterized in that at least one of the housings (30,40) includes a locking plate (42) medially positioned between the board (12) and the housing (30,40), the locking plate (42) having a plurality of through holes (66) for receiving the pins (10) and at least one gripping arm (54) extending towards the housing (30,40) adjacent to each through hole (66), and being an interference fit with a passageway in the housing (30,40) and positioned against a pin.

2. The pin field of claim 1, characterized in that the locking plate (42) includes two opposed arms (54) opposing each passageway for insertion of a pin (10) therethrough.

3. The pin field of claim 2, characterized in that each of the two opposed arms (54) has an arcuate surface along its length facing the pin surface.

4. The pin field of any one of the preceding claims, characterized in that each gripping arm (54) includes a camming surface for urging said gripping arm (54) into contact with a pin upon insertion thereof into the passageway.

## Patentansprüche

1. Elektrisches Stiftfeld mit einer gedruckten Schaltungsplatte (12), die eine Vielzahl von Stiften (10) hat, die sich zwischen deren beiden Seiten erstrecken, um Stiftkontaktabschnitte (18, 20) an gegenüberliegenden Seiten der Platte (12) zu positionieren, wobei das Stiftfeld isolierende Gehäuse (30, 40) hat, die an beiden Seiten der Platte (12) montiert sind, **dadurch gekennzeichnet**, daß wenigstens eines der Gehäuse (30, 40) eine Verriegelungsplatte (42) aufweist, die mittig zwischen der Platte (12) und dem Gehäuse (30, 40) angeordnet ist, wobei die Verriegelungsplatte (42) eine Vielzahl von Durchgangslöchern (66) zur Aufnahme der Stifte (10) und wenigstens einen Greifarm (54) hat, der sich auf das Gehäuse (30, 40) zu benachbart zu jedem Durchgangsloch (66) erstreckt und in einem Festsitz mit einem Durchgang in dem Gehäuse (30, 40) ist und gegen einen Stift positioniert ist.

2. Stiftfeld nach Anspruch 1, **dadurch gekennzeichnet**, daß die Verriegelungsplatte (42) zwei entgegengesetzte Arme (54) hat, die jedem Durchgang zum Einsetzen eines Stifts (10) dazwischen hindurch gegenüberliegen.

3. Stiftfeld nach Anspruch 2, **dadurch gekennzeichnet**, daß jeder der beiden entgegengesetzten Arme (54) eine gekrümmte Oberfläche längs seiner Länge hat, die der Stiftoberfläche gegenüberliegt.

4. Stiftfeld nach einem der vorhergehenden Ansprüche, **dadurch gekennzeichnet**, daß jeder Greifarm (54) eine Nockenfläche aufweist, um den Greifarm (54) nach dessen Einsetzen in den Durchgang in Kontakt mit einem Stift zu drücken.

## Revendications

1. Réseau de broches électriques comportant une plaquette (12) à circuit imprimé ayant plusieurs broches (10) s'étendant entre ses deux côtés pour positionner des parties de contact (8, 20) des broches sur des côtés opposés de la plaquette (12), le réseau de broches ayant des boîtiers isolants (30, 40) montés sur les deux côtés de la plaquette (12), caractérisé en ce qu'au moins l'un des boîtiers (30, 40) comprend une plaque de blocage (42) positionnée entre la plaquette (12) et le boîtier (30, 40), la plaque (42) de blocage ayant plusieurs trous traversants (66) destinés à recevoir des broches (10) et au moins un bras (54) de prise s'étendant vers le boîtier (30, 40), adjacent à chaque trou traversant (66), et réalisant un ajustement serré avec un passage dans le boîtier (30, 40) et positionné contre une broche.

2. Réseau de broches selon la revendication 1, caractérisé en ce que la plaque (42) de blocage comprend deux bras opposés (54), opposés à chaque passage pour l'insertion d'une broche (10) entre eux.

3. Réseau de broches selon la revendication 2, caractérisé en ce que chacun desdits bras opposés (54) présente une surface courbe s'étendant sur sa longueur, tournée vers la surface de la broche.

4. Réseau de broches selon l'une quelconque des revendications précédentes, caractérisé en ce que chaque bras de prise (54) présente une surface de came destinée à solliciter ledit bras de prise (54) en contact avec une broche lors d'une insertion de celle-ci dans le passage.
